(19) Europäisches Patentamt
European Patent Office
Office européen des brevets

(11) **EP 4 130 771 A1**

(12) **EUROPÄISCHE PATENTANMELDUNG**

(43) Veröffentlichungstag:
**08.02.2023   Patentblatt 2023/06**

(21) Anmeldenummer: **21189384.7**

(22) Anmeldetag: **03.08.2021**

(51) Internationale Patentklassifikation (IPC):
**G01R 31/42** (1995.01)    **H02J 3/02** (1968.09)

(52) Gemeinsame Patentklassifikation (CPC):
**H02J 3/02; G01R 27/16; G01R 31/42**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Condensator Dominit GmbH**
**59929 Brilon (DE)**

(72) Erfinder:
• **Dresel, Christian**
  **59929 Brilon (DE)**

• **Zühlke, Detlef**
  **59929 Brilon (DE)**
• **Quanz, Alexander**
  **34302 Guxhagen (DE)**
• **Völkel, Olaf**
  **59929 Brilon (DE)**
• **Schörmann, Manuel**
  **59929 Brilon (DE)**

(74) Vertreter: **Götz, Georg Alois**
**Intellectual Property IP-GÖTZ**
**Patent- und Rechtsanwälte**
**Am Literaturhaus, Königstrasse 70**
**90402 Nürnberg (DE)**

(54) **ÜBERWACHUNGSSYSTEM FÜR EIN WECHSELSTROM-FILTER**

(57)    Verfahren zur Überwachung eines Wechselstrom-Filters, welches insbesondere zur Blindleistungskompensation oder zur Reduktion von Oberschwingungen ausgebildet ist, und das Filter in Verbindung mit einem ein- oder mehrphasigen Netz (1) zur Energieverteilung betrieben wird und eine Impedanz mindestens mit einer induktiven und einer kapazitiven Komponente (L11; C11, C12) aufweist, und eine am Filter vom Netz (1) aus abfallende Spannung und ein das Filter vom Netz (1) aus durchfließender Strom gemessen werden,

**dadurch gekennzeichnet, dass**

im laufenden Filter-Betrieb die Impedanz des Filters bestimmt und überwacht wird, indem bei unterschiedlichen Netzfrequenzen permanent oder wiederholt jeweils Spannungs- und Strommessungen (M01, M02, M03; M11, M21, M31) durchgeführt werden, und entsprechende Messdaten zur Ableitung oder Berechnung von Induktivitäts- und Kapazitätswerten der mindestens einen induktiven und kapazitiven Komponente (L11; C11, C12) verwendet werden, und die berechneten Werte mit vorbestimmten oder früher berechneten Induktivitäts- und Kapazitätswerten verglichen und auf Veränderungen hin überwacht werden, und die Vergleichs- oder Überwachungsergebnisse oder eine Bewertung der Vergleichs- oder Überwachungsergebnisse unmittelbar und/oder mittelbar ausgegeben und/oder angezeigt werden.

Fig. 1

**Beschreibung**

Die Erfindung betrifft ein Verfahren zur Überwachung eines Wechselstrom-Filters, welches insbesondere zur Blindleistungskompensation oder zur Reduktion von Oberschwingungen ausgebildet ist, und das Filter in Verbindung mit einem ein- oder mehrphasigen Netz zur Energieverteilung betrieben wird und eine Impedanz mindestens mit einer induktiven und einer kapazitiven Komponente aufweist, und eine am Filter vom Netz aus abfallende Spannung und ein das Filter vom Netz aus durchfließender Strom gemessen werden.

Die Erfindung betrifft außerdem ein Wechselstrom-Filter insbesondere zur Durchführung dieses Verfahrens. Das Filter ist mit einer Überwachungssteuerung versehen, welche Schnittstellen zur Erfassung von durch das Filter fließendem Strom und von am Filter abfallender Spannung aufweist.

Ferner betrifft die Erfindung die Verwendung von im genannten Netz auftretenden Verzerrungen, Oberschwingungen und/oder Schwankungen einer Grundschwingungsfrequenz zur Bestimmung und Überwachung der Impedanz eines Wechselstrom-Filters, das mit dem Netz verbunden ist.

Die Erfindung ist besonders geeignet für Filter-Applikationen bei Mittelspannungsnetzen, ist aber auch auf allen anderen Spannungsebenen einschließlich der Niederspannungsebene einsetzbar.

Fehler und Ausfälle in Filterkreis- oder Kompensationsanlagen können unterschiedliche Ursachen haben wie Überlastungen, Fehlbelastungen aus dem Versorgungsnetz (zusätzliche Oberschwingung-Erzeuger im Netz), mechanische Fremdeinwirkungen z.B. durch Tiere, Windlastbeanspruchung, Alterung der Komponenten insbesondere der Isolierstoffe (z.B. durch Einwirkung von UV-Licht). Typischerweise kommt es dann zu einer Überbelastung über einen längeren Zeitraum. Daraus resultiert zumeist ein Temperaturanstieg und somit eine thermische Überbelastung an Kondensatoren, Drosseln oder Widerständen. In diesen Fällen bauchen Kondensatoren auf, und bei unzureichenden Schutzvorkehrungen platzt das Gehäuse auf und Öl tritt aus. Es ist zu beobachten, dass es wiederholt zu Bränden an den Kondensatoren nach geborstenen Gehäusen kommt, da keine oder nur unzureichende Schutzüberwachungen vorhanden waren.

Noch gravierender ist ein Anlagenausfall wegen Störlichtbogen. Dieser kann als Folge einer fehlerhaften Isolation (z.B. Mikrorisse wegen Windlast) bzw. eines Komponentendefektes auftreten, kann aber auch durch Fremdeinwirkungen beispielsweise durch Tiere bedingt sein. Bei einem Störlichtbogen, welcher durch einen Komponentendefekt ausgelöst wird, sind im Wesentlichen Alterungsfaktoren die Ursache. Eine wesentliche Auswirkung eines Störlichtbogens besteht im Auftreten einer Temperatur von bis zu 10.000 K. Dabei kommt es innerhalb einer relativ kurzen Zeit (wenige Millisekunden) zu einer Erwärmung der Luft im Innenraum der fehlerbehafteten Anlage. Mit der raschen Erwärmung geht eine schlagartige Ausdehnung der Luft einher. Aus den genannten Auswirkungen und dem mit dem Störlichtbogen verbundenen Fehlerstrom resultieren Gefahren für Menschen und Anlage.

Es ist bekannt, als Online-Diagnose die Unsymmetrieüberwachung von Kondensatoren anzuwenden. Dabei wird der Strom zwischen zwei Sternpunkten meßtechnisch erfasst und ausgewertet. Von Nachteil ist, dass die Unsymmetrieüberwachung nur die Symmetrie der Kondensatoren diagnostiziert. Ein etwaiger Windungsschluss der Induktivität oder anderweitig vorgelagerte Fehler werden mittels einer Unsymmetrieüberwachung nicht detektiert.

Aus EP 3 065 247 B1 (älteres Patent des Anmelders) ist ein passives Filter für Wechselstrom-Oberschwingungen zur Reduktion von Verzerrungen oder Oberschwingungen einer Grundfrequenz eines elektrischen Energieverteilnetzes bekannt. Die Schaltungsanordnung umfasst induktive, kapazitive und gegebenenfalls ohmsche Komponenten. Eine Regel- und Steuerungseinrichtung erfasst die Strom- und Leistungsbelastung des Filters über einen Stromsensor sowie einen Spannungsabfall an einer Drossel des Filters. Damit einer maximalen Strom-, Spannungs- oder Leistungsbelastbarkeit Rechnung getragen wird, wird über die Steuerungseinrichtung die Abstimmfrequenz oder Impedanz des Filters durch Ab- oder Zuschaltung von Induktivitäts- oder Kapazitätsanteilen entsprechend geändert. Falls auch bei der am niedrigsten einstellbaren Abstimmfrequenz Überlast eintritt, wird der Filterkreis abgeschaltet, und die Steuereinrichtung erzeugt eine Alarmmeldung.

Im Stand der Technik sind bereits viele Maßnahmen bekannt, um Schäden zu minimieren. Besser wäre es aber, einen Schaden von vorneherein zu verhindern.

Es ist die Aufgabe der vorliegenden Erfindung, die Nachteile im Stand der Technik zu vermeiden und ein Echtzeit-Überwachungssystem für Wechselstrom-Filter zu schaffen, welches eine vollständigere Fehlerdiagnose und -prognose für einzelne Filterkomponenten ermöglicht.

Die Aufgabe wird gelöst durch das im Anspruch 1 angegebene Überwachungsverfahren für Wechselstrom-Filter, das im Anspruch 10 angegebene Wechselstrom-Filter und die im Anspruch 15 angegebene Verwendung von Verzerrungen, Oberschwingungen und/oder Schwankungen einer Grundschwingungsfrequenz im Netz zur Bestimmung und Überwachung der Impedanz eines Wechselstrom-Filters.

Gemäß der Berechnung komplexer Impedanzen gilt für ein Wechselstrom-Filter:

$$Zfil = ZL + ZC$$

Da sowohl ZL als auch ZC direkt oder indirekt proportionale Funktionen der Frequenz sind, ist ZFil ebenfalls eine Funktion der Frequenz.

Misst man die Impedanz des Filters bei zwei oder mehreren Frequenzen, kann man durch Auflösungeines linearen Gleichungssystems ZC und ZL berechnen und daraus wiederum L und C ermitteln, wie mit nachstehendem Rechenbeispiel veranschaulicht:

$$R + j\omega_1 L + \frac{1}{j\omega_1 C_1} = \underline{Z}_1 = \frac{\underline{U}_1}{\underline{I}_1} \qquad\qquad \omega_1 \neq \omega_2 \neq \omega_3$$

$$R + j\omega_2 L + \frac{1}{j\omega_2 C} = \underline{Z}_2 = \frac{\underline{U}_2}{\underline{I}_2}$$

$$R + j\omega_3 L + \frac{1}{j\omega_3 C} = \underline{Z}_3 = \frac{\underline{U}_3}{\underline{U}_3}$$

wobei R für eine ohmsche Komponente, L für die induktive Komponente und C für die kapazitive Komponente des Filters stehen. ω ist die Kreisfrequenz und j die imaginäre Einheit.

Mittels Matrizen Rechnung und-Umformung

$$\Rightarrow \begin{bmatrix} 1 & j\omega_1 & \frac{1}{j\omega_1} \\ 1 & j\omega_2 & \frac{1}{j\omega_2} \\ 1 & j\omega_3 & \frac{1}{j\omega_3} \end{bmatrix} \begin{bmatrix} R \\ L \\ \frac{1}{C} \end{bmatrix} = \begin{bmatrix} \underline{Z}_1 \\ \underline{Z}_2 \\ \underline{Z}_3 \end{bmatrix}$$

$$\begin{bmatrix} R \\ L \\ \frac{1}{C} \end{bmatrix} = \begin{bmatrix} 1 & j\omega_1 & \frac{1}{j\omega_1} \\ 1 & j\omega_2 & \frac{1}{j\omega_2} \\ 1 & j\omega_3 & \frac{1}{j\omega_3} \end{bmatrix}^{-1} \begin{bmatrix} \underline{Z}_1 \\ \underline{Z}_2 \\ \underline{Z}_3 \end{bmatrix}$$

Wie eine Determinanten-Berechnung zeigen würde, ist das in Matrizenform dargestellte, lineare Gleichungssystem lösbar.

Im Rahmen einer technischen Realisierung, insbesondere Implementierung auf einem Mikrocomputer, lässt sich mittels dieser mathematisch-physikalischen Zusammenhänge eine etwaige Veränderung von L und C in Echtzeit beobachten und bewerten und, wenn notwendig, die Ausgabe einer Warnung oder Zwangsabschaltung der Anlage ermöglichen.

Die Erfindung beinhaltet ein Verfahren zur Überwachung von Wechselstrom-Filtern, beispielsweise Kompensationsanlagen und Filterkreisanlagen, mithilfe einer Impedanzüberwachung, welche sich dadurch auszeichnet, dass im laufenden Betrieb permanent, regelmäßig, z.B. innerhalb äquidistanter Zeitintervalle, oder zumindest wiederholt die Impedanz bei verschiedenen Frequenzen gemessen wird. Aus den Messdaten lassen sich aktuelle Kapazitäts- und Induktivitätswerte des Filters ableiten. Diese gemessenen Istwerte werden mit den Sollwerten gemäß Erstauslieferung oder Inbetriebnahme des Filters laufend verglichen.

Erfindungsgemäß werden die Netzspannung und der Filterstrom bei einer bestimmten Frequenz, beispielsweise bei Netzgrundfrequenz, und zusätzlich auch bei einer oder mehreren anderen, im Energieversorgungsnetz auftretenden Frequenzen, insbesondere bei einer oder mehreren, existierenden Störfrequenzen, gemessen. Aus diesen Messdaten werden insbesondere auf der Basis der oben dargestellten, mathematisch-physikalischen Zusammenhänge momentane die Kapazität und die Induktivität des Wechselstrom-Filters, insbesondere der Kompensations- oder Filterkreisanlage, berechnet. Durch den Vergleich mit Ursprungs- oder Originalwerten (z.B. Prüfprotokoll des Filter-Herstellers) kann eine Veränderung physikalischer Parameter des Filters erkannt und, wenn notwendig, die Anlage frühzeitig abgeschaltet werden, bevor eine ernsthafte Gefährdung entsteht.

So liegt es im Rahmen einer besonderen Erfindungsausbildung, dass die Bewertung der Vergleichs- oder Überwachungsergebnisse eine Feststellung einer etwaigen Veränderung eines oder mehrerer der aktuell berechneten Induktivitäts- und Kapazitätswerte über ein vorbestimmtes Maß hinaus umfasst, und daraufhin der Filterbetrieb vorzugsweise unmittelbar oder präventiv beendet und/oder ein Warn- oder Alarmsignal ausgegeben wird.

Gemäß einer Erfindungsausbildung werden die Spannungs- und Strommessungen bei einer Grundschwingungsfrequenz des Netzes und bei mindestens einer im Netz existierenden Störfrequenz insbesondere einer Oberschwingung oder sonstigen Verzerrung durchgeführt. Alternativ oder zusätzlich können die Spannungs- und Strommessungen bei einer oder mehreren Testfrequenzen erfolgen, die in einem externen, mittelbar (beispielsweise über das Netz) oder unmittelbar mit dem Filter gekoppelten Frequenzgenerator erzeugt werden, wobei Signale unterschiedlicher Frequenz in das Filter eingespeist werden.

Bei der erfindungsgemäß durchgeführten Spannungs- und Strommessung erhält man in der Regel ein Gemisch verschiedener Frequenzen. Mittels mathematischer Methoden, beispielsweise der an sich bekannten Fourier-Analyse, lässt sich ein Signalverlauf bestimmter oder besonders interessierender Frequenz, z.B. bei 250 Hz, identifizieren, und die dazu gemessenen Strom- und Spannungswerte werden dann gezielt für die erfindungsgemäße Überwachung verwendet. Eine auf dem Mikrocomputer ablauffähige Software zur Implementierung solcher mathematischer Methoden ist heutzutage leicht und kostengünstig verfügbar.

In dieser Hinsicht besteht eine zweckmäßige Erfindungs-Ausführungsvariante darin, bei den Spannungs- und Strommessungen mittels einer Fourier-Analyse oder sonstiger mathematischer Frequenz-Analysemethoden im Netz auftretende Schwingungen oder sonst in das Filter (beispielsweise aus einem externen Frequenzgenerator) eingespeiste Schwingungssignale über ihre jeweiligen Frequenzen zu identifizieren und für die Impedanz-Überwachung zu verwenden.

Bei einem einschlägigen Wechselstrom-Filter mit Kondensatoren, Drosseln und Widerständen oder nur mit Drosseln und Kondensatoren braucht man drei bzw. zwei Strom- und Spannungsmessungen, um C, L und R bzw. L und C zu bestimmen, und damit auf den Zustand der Impedanz oder der Komponenten im Filtersystem zu schließen. Diesen Zustand kann man mit einem Urzustand bei Inbetriebnahme oder ab Werk vergleichen. Dann kann man entscheiden, ob die Abweichung vom Urzustand noch innerhalb normaler Toleranzen wie z.B. Temperaturschwankungen, Luftdruckschwankungen und anderes liegt. Bei zu großen Abweichungen wird der Filterbetrieb beispielsweise abgeschaltet.

In dieser Hinsicht besteht eine Erfindungsausbildung darin, dass zwischen früher und später berechneten Induktivitäts- und/oder Kapazitätswerten Differenzen gebildet und auf ein Überschreiten eines vorbestimmten Maßes hin überwacht werden, oder berechnete Induktivitäts- und Kapazitätswerte zu einander ins Verhältnis gesetzt werden, und das jeweilige Verhältnis auf ein vorbestimmtes Maß hin überwacht wird.

Im Rahmen einer zweckmäßigen Erfindungsvariante werden als vorbestimmte Induktivitäts- und Kapazitätswerte ab Werkslieferung geltende Originalwerte des oder der induktiven und kapazitiven Komponente(n) verwendet. Alternativ und/oder zusätzlich können Sollwerte, die bei einer Inbetriebnahme oder nach Wartungsarbeiten festgestellt bzw. bestimmt werden, als vorbestimmte Induktivitäts- und Kapazitätswerte verwendet werden. Zweckmäßig dienen die Sollwerte dann als Bezugsgrößen.

Im Rahmen der Erfindung wird gemäß einer besonderen Ausführung die Schwankung der Grundschwingungsfrequenz des Netzes für die Überwachung der Filter Impedanz verwendet. Strom und Spannung werden bei den im Bereich der Schwankungen liegenden unterschiedlichen Frequenzen gemessen, und die Messdaten für die Impedanz-Überwachung verarbeitet.

Es liegt im Rahmen erfindungsgemäßer Weiterbildungen, das erfindungsgemäße Überwachungssystem mit einer Betriebsweise für passive Wechselstrom-Oberschwingungsfilter, die der Reduktion von Verzerrungen und Oberschwingungen dienen, zu kombinieren. Dabei werden mittels anfänglicher Dimensionierung der einen oder mehreren induktiven und/oder kapazitiven Komponenten und gegebenenfalls einer oder mehrerer ohmschen Komponenten des Filters dessen Abstimmfrequenz und/oder Impedanz eingestellt. Während des laufenden Filter-Betriebs werden ohne dessen Unterbrechung je nach Strom- oder sonstiger Leistungsbelastung des Filters die Abstimmfrequenz und/oder Impedanz entsprechend einer vorgegebenen, maximalen Strom- oder sonstigen Leistungsbelastbarkeit des Filters so verändert, dass dessen Grenze zur Strom- oder Leistungs-Überlastung nicht überstiegen wird.

Bei einer anderen Ausbildung der Erfindung mit Nutzung eines mehrphasigen Wechselstromnetzes werden bei der Spannungsmessung eine Phasen-Strangspannung des Netzes gegen einen geerdeten Nullpunkt (PE) erfasst, und daraus eine zwischen zwei Phasenleitern bzw. Netzphasen am Filter abfallende oder anliegende Phasen-Phasen-Spannung berechnet, welche dann für die Überwachung des (jeweiligen) Filters verwendet wird.

Indem gemäß einer Erfindungsausbildung die Filter-Komponenten zum Einsatz für ein Mittelspannungsnetz oder einen Mittelspannungsbereich oder für 1 kV bis 52 kV ausgelegt sind, lässt sich gerade in diesem sicherheitskritischen Feld etwaigen Havarien vorbeugen.

Im Rahmen der allgemeinen erfinderischen Idee liegt die Anordnung eines Wechselstrom-Filters mit Überwachungssteuerung, das wie oben angegeben ausgebildet ist und eine Verbindung mit dem Netz zur Energieverteilung aufweist. Die Anordnung umfasst als Verbindung ein oder mehrere Schaltmittel, welche von der Filter-Überwachungssteuerung und gegebenenfalls unter Steuerungskontrolle durch die Ausgabeschnittstelle der Überwachungssteuerung angesteuert und betätigt oder ansteuerbar und betätigbar sind.

Im Rahmen der allgemeinen erfinderischen Idee liegt auch ein Überwachungssystem mit Wechselstrom-Filter, das wie oben angegeben ausgebildet ist und mit dem Netz zur Energieverteilung verbunden ist. An das Netz ist dabei ein Frequenzgenerator angekoppelt, mittels welchem Signale vorbestimmter, unterschiedlicher Frequenzen in das Netz eingeprägt werden, sodass bei der Strom- und Spannungsmessung im Filter diese Signale mit erfasst werden.

Weitere Einzelheiten, Merkmale, Merkmals- (Unter-)Kombinationen, Vorteile und Wirkungen auf der Basis der Erfindung ergeben sich aus der nachfolgenden Beschreibung bevorzugter, beispielhafter Ausführungsformen der Erfindung und den Zeichnungen. Diese zeigen in

Fig. 1     ein Übersichtsschaltbild der Anordnung des Wechselstrom-Filters mit/an einem Energieverteilnetz,

Fig. 2     ein auf die Anordnung nach Figur 1 bezogenes Spannungsdreieck

Figur 3     ein Flussdiagramm, bezogen auf die in Figur 1 gezeigte Überwachungssteuerung

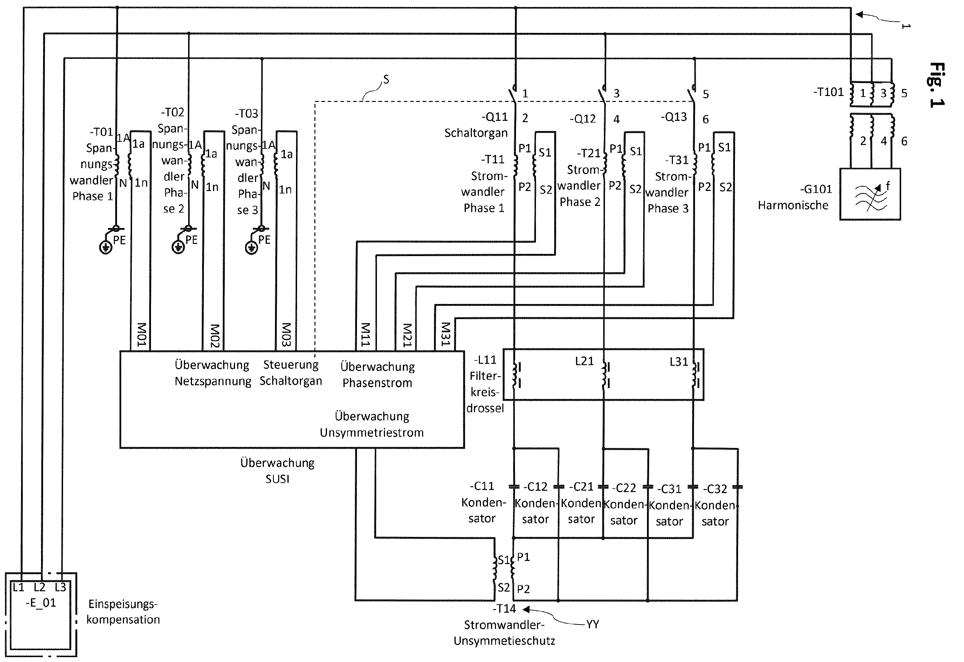

Der in Figur 1 dargestellte Wechselstrom-Filterkreis für ein dreiphasiges Energieverteilungs-Netz 1 kann unter anderem der Reduktion von Oberschwingungen oder der Blindleistungskompensation dienen. Die Möglichkeit der Blindleistungskompensation ist in der Zeichnung mit einer KompensationsEinspeisungseinrichtung E01 angedeutet, in welche drei Netzphasen L1, L2, L3 des Netzes 1 münden. Im Rahmen des Filterkreises ist je einer der drei Netzphasen L1, L2, L3 ein Wechselstrom-Filter mit einer Impedanz zugeordnet, welche ausgemacht wird durch eine als induktive Komponente dienende Filterkreisdrossel L11, L21 bzw. L31 und eine dazu in Serie angeordnete Parallelschaltung zweier Kondensatoren C11, C12 bzw. C21, C22 bzw. C31, C32, welche die kapazitive Komponente des jeweiligen Wechselstrom-Filters bildet.

Zur Erkennung von Fehlern und Ausfällen bei den Kondensatoren ist ein an sich bekannter Unsymmetrieschutz eingerichtet, indem die Kondensatoren im Doppelstern (YY) verschaltet sind. Der Unsymmetrieschutz arbeitet auf der Basis von Ausgleichsströmen, die bei Verletzung der Symmetrie unter den Kondensatoren auftreten. Die Ausgleichsströme werden von einer beispielsweise mittels Mikrocomputer realisierten Überwachungssteuerung SUSI mit entsprechender Meßschnittstelle über einen Unsymmetrie-Stromwandler T14 erfasst, welcher die etwaigen Ausgleichsströme detektiert. Die bei der Erfassung anfallenden Messdaten werden dann im Sinne einer spezifizierten Überwachungsstrategie in der Überwachungssteuerung SUSI weiterverarbeitet.

Die Überwachungssteuerung SUSI besitzt weitere, je einer der drei Netzphasen L1, L2, L3 zugeordnete Strommeßschnittstellen M11, M21, M31, welche jeweils mit einer Sekundärseite dreier Phasenstromwandler T11, T21 bzw. T31 verbunden sind. Deren jeweilige, zweipolige Primärseiten stehen mit einem Anschlusspol mit einer jeweils zugeordneten Netzphase L1, L2 bzw. L3 und mit dem anderen Anschlusspol mit dem jeweils zugeordneten Wechselstrom-Filter L11, C11, C12 bzw. L21, C21, C22 und L31, C31, C32 in Verbindung. Mithin können über diese Strommeßschnittstellen der jeweilige Phasenstrom von der Netzphase L1, L2 bzw. L3 durch das zugeordnete Filter erfasst, entsprechende Messdaten generiert und für eine Überwachung der jeweiligen Filterimpedanz verwendet werden.

Zur Ermittlung und Überwachung der Filterimpedanzen sind ferner Messungen der am jeweiligen Filter von der zugeordneten Netzphase L1, L2, L3 aus abfallenden Spannungen notwendig. Dazu sind drei, je einer Netzphase L1, L2, L3 zugeordnete Phasenspannungswandler T01, T02, T03 angeordnet. Deren zweipolige Primärseiten sind mit einem Anschlusspol an einer jeweiligen Netzphase L1, L2, L3 und mit dem anderen Anschlusspol auf Masse bzw. Bezugspotenzial PE gelegt.

Mithin fällt über die Primärseite des jeweiligen Phasenspannungswandlers eine Netzstrangspannung ab, welche um den an sich bekannten Drehstrom-Verkettungsfaktor $1/\sqrt{3}$ kleiner ist als die Phasen-Phasen-Spannung zwischen zwei Netzphasen L1, L2 bzw L1, L3 bzw L2, L3, welche direkt am jeweiligen Filter abfallen. Infolgedessen müssen die Messwerte um den Verkettungsfaktor $\sqrt{3}$ vergrößert werden, was entweder durch entsprechende Verschaltung im jeweiligen Spannungswandler T01, T02, T03 realisiert (an sich bekannt) oder mit einer entsprechende Umrechnungsroutine in der nachgeordneten Überwachungssteuerung SUSI programmiert sein kann.

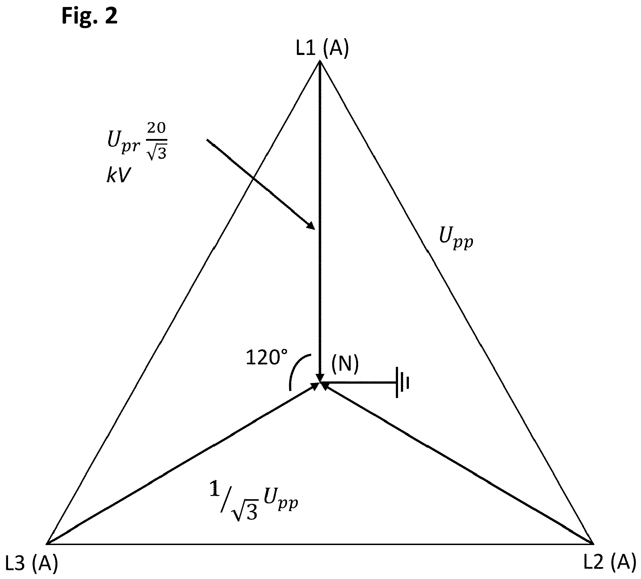

In Figur 2 ist der zugrundeliegende elektrotechnische Zusammenhang mit einem Zeigerbild der Netzstrangspannungen Upr (in Sternschaltung auf einen Nullpunkt N bzw. Masse gelegt) veranschaulicht. Die Phasen-Phasen-Spannungen Upp zwischen den Netzphasen L1, L2 bzw. L1, L3 bzw. L2 L3 sind ebenfalls angedeutet.

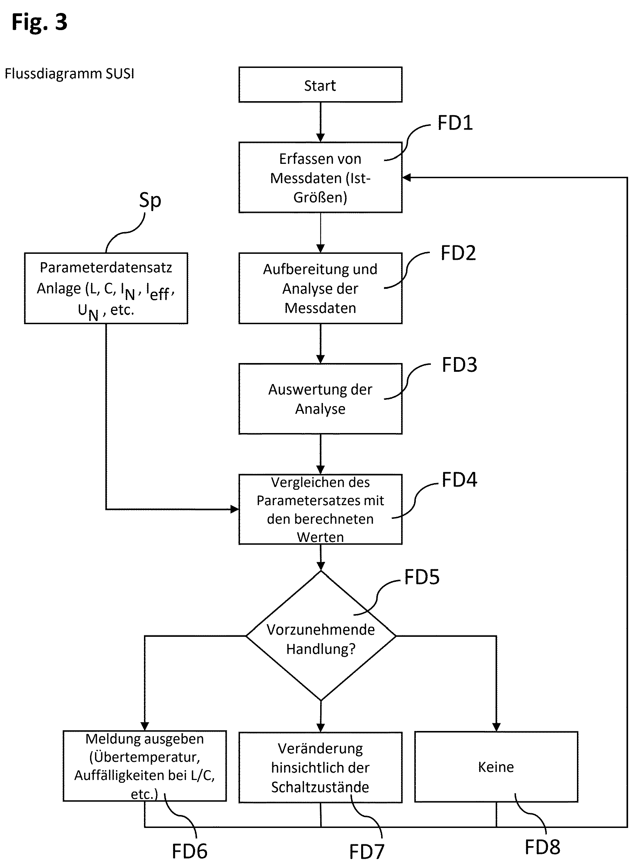

Gemäß Figur 1 sind die zugehörigen Sekundärseiten der Spannungswandler T01, T02, T03 sind mit jeweiligen Spannungsmeßschnittstellen M01, M02, M03 der Überwachungssteuerung SUSI verbunden, worüber die jeweilige Phasen-Phasen-Spannung bzw. Netzspannung (entsprechend der Netzphasen L1, L2, L3) gemessen werden kann. Resultierende Messdaten können dann durch in der Überwachungssteuerung SUSI implementierte Software (siehe Figur 3 und zugehörige Beschreibung) im Sinne einer Impedanz-Überwachung weiterverarbeitet werden.

Wird durch den in der Überwachungssteuerung SUSI ablaufenden Überwachungsprozess eine unzulässige Veränderung einer Filter-Impedanz oder einer oder mehrerer, zugehöriger induktiver oder kapazitiver Filter-Komponenten gegenüber einem früheren, spezifizierten Urzustand festgestellt, beispielsweise mittels Vergleiche oder Differenzbildungen, so kann eine in der Überwachungssteuerung SUSI eingerichtete Ausgabeschnittstelle ein Abschaltsignal für einen Steuerungsausgang generieren, der über eine (gestrichelt gezeichnete) Steuerungsverbindung S parallel mit den Steuerungseingängen von je einer Netzphase L1, L2, L3 zugeordneten Schaltorganen Q11, Q12, Q13 verbunden ist. Durch das Abschaltsignal lassen sich die Schaltorgane gleichzeitig zur Unterbrechung der Verbindungen zwischen den drei Netzphasen L1, L2, L3 und den zugehörigen Wechselstrom-Filtern betätigen.

Für den seltenen Fall, dass im öffentlichen Energieverteilungsnetz 1 nicht ausreichend Störungen und Verzerrungen bei von der Grundschwingungsfrequenz abweichenden Frequenzen vorhanden sind, die für die erfindungsgemäße Impedanz-Überwachung verwendet werden könnten, ist an das Netz über einen Transformator T101 ein externer Frequenzgenerator G101 angekoppelt. Dieser dient der Erzeugung und Einspeisung von Signalen mit vorbestimmten Testfrequenzen (in der Regel abweichend von der Grundschwingungsfrequenz) in das Netz 1 bzw. dessen Netzphasen L1, L2, L3, welche dann in der Überwachungssteuerung SUSI über deren Strom- und Spannungsmeßschnittstellen M11, M21, M31 bzw. M01, M02, M03 erfasst und beispielsweise mittels Fourier-Analyse identifiziert werden können.

Das Flussdiagramm gemäß Figur 3 veranschaulicht beispielhaft ein Überwachungs-Programm, wie es intern in der mit Mikrocomputer realisierten Überwachungssteuerung SUSI ablaufen könnte. Den Rahmen bildet eine Programmschleife, innerhalb welcher ständig oder wiederholt Messwerte für Induktivität und Kapazität des Filters erfasst, ausgewertet und daraus die Induktivitäts- und Kapazitätswerte berechnet werden, die dann mit ursprünglich als Konstante abgelegten Filter-Parametern verglichen werden. Letztere können aus Prüfprotokollen der Komponenten-Hersteller ermittelt sein.

Gemäß Figur 3 erfolgt im Programmelement FD1 die Erfassung bzw. Abtastung von Ist-Größen bzw. Messdaten zur aktuellen Kapazität und Induktivität des jeweiligen Wechselstrom-Filters. In den nachfolgenden Programmelementen FD2, FD3 werden die Messdaten aufbereitet und analysiert und die Analysedaten ausgewertet. Im folgenden Programmelement FD4 werden die aus den Messdaten und Analysen gewonnenen Werte für die aktuelle Ist-Induktivität und -Kapazität mit den als Parameterdatensatz in einem Festwertspeicher Sp abgelegten, ursprünglichen Werten für Induktivität und Kapazität verglichen. Das nächste Programmelement FD5 ist eine Programmverzweigung mit drei Ausgängen, die zum Aufruf dreier alternativer Programmelemente FD6, FD7 und FD8 führen. Per Programmelement FD6 wird, nachdem per Vergleich durch Programmelement FD4 auffällige, aber momentan noch tolerierbaren Abweichungen der aktuellen Ist-Impedanz des Filters vom Urzustand festgestellt sind, eine Fehler- und/oder Warnmeldung (z.B. Übertemperatur, Auffälligkeiten bei Induktivität oder Kapazität der Filter-Impedanz oder dergleichen) über ein Ausgabeschnittstellenmodul der Überwachungssteuerung SUSI ausgegeben. Sind die festgestellten Abweichungen nicht mehr tolerierbar wegen etwaigem, zu hohen Gefahrenpotenzial, wird per Programmelement FD5 die Verzweigung zum Programmelement FD7 vorgenommen, worüber der Zustand der drei Schaltorgane Q11, Q12, Q13 dahingehend verändert wird, dass die Verbindungen der Filterkreisanlage mit den drei Wechselstrom-Filtern zum Netz 1 bzw. zu den 3 Netzphasen L1, L2, L3 unterbrochen werden. Damit sollen gefährliche Zustände ausgeschlossen werden. Liegen gemäß Vergleich durch Programmelement FD4 keine auffälligen oder zu meldenden Abweichungen vor, wird über Programmelement FD5 in das weitere, alternative Programmelement FD8 verzweigt, wodurch ein erneuter Durchlauf der Programmschleife bzw. ein erneuter Meß- und Abtastzyklus gestartet wird.

**Bezugzeichenliste**

1 - Energieverteilungs-Netz
E01 - Kompensationseinspeisungseinrichtung
L1, L2, L3 - Netzphase
L11, L21, L31 - Filterkreisdrossel
C11, C12 bzw. C21, C22 bzw. C31, C32 - Filterkreiskondensatoren
YY - Doppelstern
SUSI - Überwachungssteuerung
T14 - Unsymmetrie-Stromwandler
M11, M21, M31 - Stromeßschnittstelle

T11, T21, T31 - Phasenstromwandler
T01, T02, T03 - Phasenspannungswandler
PE - Bezugspotenzial
Upr - Netzstrangspannung
N - Nullpunkt bzw. Masse
Upp - Phasen- Phasen-Spannung
M01, M02, M03 - Spannungsmeßschnittstelle
S - Steuerungsverbindung
Q11, Q12, Q13 - Schaltorgan
T101 - Transformator
G101 - Frequenzgenerator
FD1-FD8 - Programmelemente des Flussdiagramms
Sp - Festwertspeicher

**Patentansprüche**

1. Verfahren zur Überwachung eines Wechselstrom-Filters, welches insbesondere zur Blindleistungskompensation oder zur Reduktion von Oberschwingungen ausgebildet ist, und das Filter in Verbindung mit einem ein- oder mehrphasigen Netz (1) zur Energieverteilung betrieben wird und eine Impedanz mindestens mit einer induktiven und einer kapazitiven Komponente (L11; C11, C12) aufweist, und eine am Filter vom Netz (1) aus abfallende Spannung und ein das Filter vom Netz (1) aus durchfließender Strom gemessen werden,
**dadurch gekennzeichnet, dass**
im laufenden Filter-Betrieb die Impedanz des Filters bestimmt und überwacht wird, indem bei unterschiedlichen Netzfrequenzen permanent oder wiederholt jeweils Spannungs- und Strommessungen (M01, M02, M03; M11, M21, M31) durchgeführt werden, und entsprechende Messdaten zur Ableitung oder Berechnung von Induktivitäts- und Kapazitätswerten der mindestens einen induktiven und kapazitiven Komponente (L11; C11, C12) verwendet werden, und die berechneten Werte mit vorbestimmten oder früher berechneten Induktivitäts- und Kapazitätswerten verglichen und auf Veränderungen hin überwacht werden, und die Vergleichs- oder Überwachungsergebnisse oder eine Bewertung der Vergleichs- oder Überwachungsergebnisse unmittelbar und/oder mittelbar ausgegeben und/oder angezeigt werden.

2. Verfahren nach Anspruch 1,
**dadurch gekennzeichnet, dass**
die Bewertung der Vergleichs- oder Überwachungsergebnisse eine Feststellung einer etwaigen Veränderung eines oder mehrerer der berechneten Induktivitäts- und Kapazitätswerte über ein vorbestimmtes Maß hinaus umfasst, und daraufhin der Filterbetrieb vorzugsweise unmittelbar oder präventiv beendet und/oder ein Warn- oder Alarmsignal ausgegeben wird.

3. Verfahren nach Anspruch 1 oder 2,
**dadurch gekennzeichnet, dass**
die Spannungs- und Strommessungen (M01, M02, M03; M11, M21, M31) bei einer Grundschwingungsfrequenz des Netzes (1) und bei mindestens einer im Netz existierenden Störfrequenz insbesondere einer Oberschwingung, Verzerrung oder bei einer oder mehreren Testfrequenzen aus einem externen Frequenzgenerator (G101) durchgeführt werden.

4. Verfahren nach einem der vorhergehenden Ansprüche,
**dadurch gekennzeichnet, dass**
bei den Spannungs- und Strommessungen (M01, M02, M03; M11, M21, M31) mittels einer Fourier-Analyse oder sonstiger mathematischer Frequenz-Analysemethoden im Netz auftretende Schwingungen oder sonst in das Filter eingespeiste Schwingungen über ihre jeweiligen Frequenzen identifiziert und für die Impedanz-Überwachung verwendet werden.

5. Verfahren nach einem der vorhergehenden Ansprüche,
**dadurch gekennzeichnet, dass**
zwischen früher und später berechneten Induktivitäts- und/oder Kapazitätswerten Differenzen gebildet und auf ein Überschreiten eines vorbestimmten Maßes hin überwacht werden, oder berechnete Induktivitäts- und Kapazitätswerte zu einander ins Verhältnis gesetzt werden, und das jeweilige Verhältnis auf ein vorbestimmtes Maß hin überwacht wird.

**6.** Verfahren nach einem der vorhergehenden Ansprüche,
**dadurch gekennzeichnet, dass**
als vorbestimmte Induktivitäts- und Kapazitätswerte ab Werksauslieferung geltende Originalwerte des oder der induktiven und kapazitiven Komponente(n) (L11; C11, C12) oder bei einer Inbetriebnahme oder nach Wartungsarbeiten bestimmte Sollwerte für die induktiven und kapazitiven Komponente(n) (L11; C11, C12) verwendet werden.

**7.** Verfahren nach einem der vorhergehenden Ansprüche, unter Verwendung eines eine Frequenz für Grundschwingungen aufweisenden Energieverteilnetzes (1), wobei die Grundschwingungsfrequenz zwischen unterschiedlichen Frequenzen schwankt,
**dadurch gekennzeichnet, dass**
Strom und Spannung bei den im Bereich der Schwankungen liegenden, unterschiedlichen Frequenzen gemessen werden.

**8.** Verfahren nach einem der vorhergehenden Ansprüche,
**dadurch gekennzeichnet, dass**
mittels Dimensionierung der einen oder mehreren induktiven und/oder kapazitiven Komponenten (L11; C11, C12) und gegebenenfalls einer oder mehrerer ohmschen Komponenten des Filters dessen Abstimmfrequenz und/oder Impedanz eingestellt werden, wobei während des laufenden Filter-Betriebs ohne dessen Unterbrechung je nach Strom- oder sonstiger Leistungsbelastung des Filters die Abstimmfrequenz und/oder Impedanz entsprechend einer vorgegebenen, maximalen Strom- oder sonstigen Leistungsbelastbarkeit des Filters so verändert werden, dass dessen Grenze zur Strom- oder Leistungs-Überlastung nicht überstiegen wird.

**9.** Verfahren nach einem der vorhergehenden Ansprüche, unter Verwendung eines mehrphasigen Wechselstromnetzes (1),
**dadurch gekennzeichnet, dass**
bei der Spannungsmessung (M01, M02, M03) eine Phasen-Strangspannung des Netzes gegen einen geerdeten Nullpunkt bzw. Bezugspotenzial (PE) erfasst wird, und daraus eine zwischen zwei Phasenleitern bzw. Netzphasen (L1, L2; L1, L3; L2, L3) am Filter abfallende oder anliegende Phasen-Phasen-Spannung berechnet wird, welche für die Überwachung des (jeweiligen) Filters verwendet wird.

**10.** Wechselstrom-Filter, ausgebildet insbesondere zur Blindleistungskompensation oder Reduktion von Oberschwingungen, insbesondere zur Durchführung des Verfahrens nach einem der vorhergehenden Ansprüche, welches Filter verbunden oder verbindbar ist mit einem ein- oder mehrphasigen Netz (1) zur Energieverteilung und folgendes aufweist:

- eine Impedanz mit mindestens einer induktiven und kapazitiven Komponente (L11; C11, C12),
- und ferner eine Überwachungssteuerung (SUSI) mit Schnittstellen (M01, M02, M03; M11, M21, M31) zur Erfassung von durch das Filter fließendem Strom und von am Filter abfallender Spannung,

**dadurch gekennzeichnet, dass**

die Überwachungssteuerung (SUSI) programm- und/oder schaltungstechnisch dazu eingerichtet und ausgebildet ist, im laufenden Filter-Betrieb die Impedanz des Filters zu überwachen, indem bei unterschiedlichen Frequenzen permanent oder wiederholt jeweils Spannungs- und Strommessungen über die Schnittstellen (M01, M02, M03; M11, M21, M31) durchgeführt werden,
und die Überwachungssteuerung (SUSI) mit einem Rechensystem versehen ist, das programm- und/oder schaltungstechnisch zu folgendem eingerichtet oder ausgebildet ist:

- aus den Spannungs- und Strommessungen oder Spannungs- und Strommessschnittstellen (M01, M02, M03; M11, M21, M31) jeweils unterschiedlichen Frequenzen entsprechende oder zugeordnete Messdaten zu generieren, und
- aus den Messdaten Induktivitäts- und Kapazitätswerte der mindestens einen induktiven und kapazitiven Komponente (L11; C11, C12) abzuleiten oder zu berechnen,

und in der Überwachungssteuerung (SUSI) ferner ein oder mehrere Vergleichsmittel (FD4) dazu eingerichtet und/oder ausgebildet sind, die abgeleiteten/berechneten Werte mit vorbestimmten oder früher gespeicherten Induktivitäts- und Kapazitätswerten zu vergleichen,
und in der Überwachungssteuerung (SUSI) ferner ein oder mehrere Überwachungsmittel eingerichtet und dazu ausgebildet sind, die resultierenden Vergleichsergebnisse auf Veränderungen hin zu überwachen,
und die Überwachungssteuerung (SUSI) ferner mit einer oder mehreren Ausgabeschnittstellen (FD6, FD7) versehen ist, um die Vergleichs- oder Überwachungsergebnisse und/oder eine Bewertung der Vergleichs- und/oder Überwachungsergebnisse unmittelbar und/oder mittelbar auszugeben oder anzuzeigen.

11. Filter nach einem der vorhergehenden Ansprüche,
**gekennzeichnet durch**
eine Auslegung seiner Komponenten (T01, T02, T03; T11, T21, T 31; L11, C11, C12) für ein Mittelspannungsnetz oder einen Mittelspannungsbereich oder für 1 kV bis 52 kV.

12. Anordnung eines eine Überwachungssteuerung aufweisenden Wechselstrom-Filters, das nach einem der vorhergehenden Ansprüche ausgebildet ist, in Verbindung mit einem Netz (1) zur Energieverteilung,
**dadurch gekennzeichnet, dass**
die Anordnung ein oder mehrere Schaltmittel (Q11, Q12, Q13) umfasst, über welche das Filter zu seinem Betrieb an das Netz (1) angeschlossen ist, und das oder die Schaltmittel (Q11, Q12, Q13) von der Überwachungssteuerung (SUSI) des Filters, insbesondere unter Steuerungskontrolle von deren Ausgabeschnittstelle (FD7), angesteuert oder ansteuerbar oder betätigt oder betätigbar sind.

13. Überwachungssystem mit einem Wechselstrom-Filter, das nach einem der vorhergehenden Ansprüche ausgebildet ist und an ein Netz (1) zur Energieverteilung, insbesondere Mittelspannungsnetz, angeschlossen ist,
**gekennzeichnet durch**
einen Frequenzgenerator (G 101), der an das Netz (1) angekoppelt und zum Einprägen von Signalen vorbestimmter, unterschiedlicher Frequenzen in das Netz ausgebildet ist.

14. Verwendung von Verzerrungen, Oberschwingungen und/oder Schwankungen einer Grundschwingungsfrequenz in einem der Energieverteilung dienenden Netz (1) zur Bestimmung und Überwachung der Impedanz eines insbesondere nach einem der vorhergehenden Ansprüche ausgebildeten Wechselstrom-Filters, indem anhand von wenigstens zwei Spannungs- und Strommessungen (M01, M02, M03; M11, M21, M31), welche bei wenigstens zwei unterschiedlichen Meßfrequenzen vorgenommen werden, die Kapazität (C11, C12) und die Induktivität (L11) des Filters bestimmt und mit vorgegebenen und/oder vorausgehend berechneten Kapazitäts- und Induktivitätswerten verglichen werden, wobei wenigstens eine Meßfrequenz einer der Verzerrungen, Oberschwingungen oder Schwankungen im Netz entspricht.

15. Verwendung nach Anspruch 14,
**gekennzeichnet durch**
eine Anwendung des Überwachungsverfahrens nach einem der vorhergehenden Ansprüche.

## Fig. 1

**Fig. 2**

# Fig. 3

Flussdiagramm SUSI

Start

FD1
Erfassen von Messdaten (Ist-Größen)

Sp

Parameterdatensatz Anlage (L, C, $I_N$, $I_{eff}$, $U_N$, etc.

FD2
Aufbereitung und Analyse der Messdaten

FD3
Auswertung der Analyse

FD4
Vergleichen des Parametersatzes mit den berechneten Werten

FD5
Vorzunehmende Handlung?

Meldung ausgeben (Übertemperatur, Auffälligkeiten bei L/C, etc.)

Veränderung hinsichtlich der Schaltzustände

Keine

FD6 FD7 FD8

**Europäisches Patentamt**
**European Patent Office**
**Office européen des brevets**

# EUROPÄISCHER RECHERCHENBERICHT

Nummer der Anmeldung

EP 21 18 9384

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 2 881 748 A1 (ROCKWELL AUTOMATION TECH INC [US]) 10. Juni 2015 (2015-06-10) | 1-7, 9-11, 13-15 | INV. G01R31/42 H02J3/02 |
| Y | * Abbildungen 4,5 * <br> * Absätze [0001], [0003], [0004], [0018] - [0021], [0023] * <br> ----- | 8,12 | |
| Y,D | EP 3 065 247 B1 (CONDENSATOR DOMINIT DR CHRISTIAN DRESEL GES FÜR LEISTUNGSELEKTRONIK EN) 10. Mai 2017 (2017-05-10) <br> * Absätze [0001], [0019] - [0021] * <br> ----- | 8,12 | |

RECHERCHIERTE SACHGEBIETE (IPC)

G01R
H02J

Der vorliegende Recherchenbericht wurde für alle Patentansprüche erstellt

| Recherchenort | Abschlußdatum der Recherche | Prüfer |
|---|---|---|
| München | 19. November 2021 | Zettler, Karl-Rudolf |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 21 18 9384

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-11-2021

| Im Recherchenbericht angeführtes Patentdokument | Datum der Veröffentlichung | Mitglied(er) der Patentfamilie | Datum der Veröffentlichung |
|---|---|---|---|
| EP 2881748 A1 | 10-06-2015 | BR 102014030057 A2 | 02-08-2016 |
| | | CN 104698277 A | 10-06-2015 |
| | | EP 2881748 A1 | 10-06-2015 |
| | | US 2015153397 A1 | 04-06-2015 |
| EP 3065247 B1 | 10-05-2017 | DE 202016100226 U1 | 18-02-2016 |
| | | EP 3065247 A1 | 07-09-2016 |
| | | ES 2634668 T3 | 28-09-2017 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3065247 B1